Europäisches Patentamt

European Patent Office

Office européen des brevets

(19)

(11) **EP 0 530 666 B1**

(12) **EUROPÄISCHE PATENTSCHRIFT**

(45) Veröffentlichungstag und Bekanntmachung des Hinweises auf die Patenterteilung:
**29.10.1997 Patentblatt 1997/44**

(51) Int Cl.$^6$: **H03M 1/52**

(21) Anmeldenummer: **92114566.0**

(22) Anmeldetag: **27.08.1992**

(54) **Verfahren zur Wandlung eines Analogsignals in ein Digitalsignal**

Method of converting an analog signal in a digital signal

Procédé de conversion d'un signal analogique en un signal numérique

(84) Benannte Vertragsstaaten:
**CH DE FR GB IT LI NL**

(30) Priorität: **02.09.1991 DE 4129150**
**17.09.1991 DE 4130826**

(43) Veröffentlichungstag der Anmeldung:
**10.03.1993 Patentblatt 1993/10**

(73) Patentinhaber: **KROHNE MESSTECHNIK GMBH & CO. KG**
**D-47058 Duisburg (DE)**

(72) Erfinder:
• **Florin, Wilhelm, Dipl.-Ing.**
**W-4100 Duisburg 17 (DE)**
• **Ludwig, Detlev, Dipl.-Ing.**
**W-4100 Duisburg 14 (DE)**

(74) Vertreter: **Gesthuysen, Hans Dieter, Dipl.-Ing.**
**Patentanwälte**
**Gesthuysen, von Rohr, Weidener,**
**Schüll, Häckel,**
**Postfach 10 13 54**
**45013 Essen (DE)**

(56) Entgegenhaltungen:
**US-A- 4 268 820**          **US-A- 4 357 600**

• **IEEE TRANSACTIONS ON INSTRUMENTATION AND MEASUREMENT Bd. IM-34, Nr. 4PT2 , Dezember 1984 , NEW YORK, USA Seiten 630 - 635 TAHA 'speed improvements for dual-slope a/d converters'**

**Beschreibung**

Die Erfindung betrifft ein Verfahren zur Wandlung eines Analogsignals in ein Digitalsignal, nämlich einer analogen Eingangsspannung in ein der Eingangsspannung proportionales digitales Ausgangssignal, bei dem die Eingangsspannung während einer vorgegebenen Aufintegrationszeit auf eine Integratorspannung aufintegriert wird, nach Ablauf der Aufintegrationszeit die Integratorspannung während einer Abintegrationszeit durch eine Referenzspannung auf Null abintegriert wird, aus dem Verhältnis von Abintegrationszeit zu Aufintegrationszeit, multipliziert mit der Referenzspannung die Eingangsspannung bestimmt wird und während der Aufintegrationszeit der Eingangsspannung Aussteuerimpulse überlagert werden.

Verfahren zur Wandlung eines Analogsignals in ein Digitalsignal sind vielfach bekannt; insbesondere sind das Parallelverfahren, das Wägeverfahren und das Zählverfahren bekannt.

Beim Parallelverfahren wird die Eingangsspannung gleichzeitig mit n Referenzspannungen verglichen; man stellt fest, zwischen welchen beiden Referenzspannungen die Eingangsspannung liegt. Auf diese Weise erhält man das der Eingangsspannung proportionale digitale Ausgangssignal, also eine bestimmte Zahl, in einem Schritt. Allerdings ist der Aufwand sehr hoch, da man für jede mögliche Zahl einen Komparator benötigt. Für einen Meßbereich von 0 bis 100 in Schritten von Eins benötigt man also n = 100 Komparatoren.

Beim Wägeverfahren wird nicht das ganze Ergebnis in einem Schritt gebildet, vielmehr wird jeweils nur eine Stelle der Zahl (als Dualzahl) ermittelt. Dabei beginnt man mit der höchsten Stelle und stellt fest, ob die Eingangsspannung größer oder kleiner ist als die Referenzspannung für die höchste Stelle. Ist sie größer, setzt man die höchste Stelle auf Eins und subtrahiert die Referenzspannung. Den Rest vergleicht man mit der nächstniedrigeren Stelle usw.. Man benötigt also so viele Schritte, wie die Zahl Stellen besitzt, und ebenso viele Referenzspannungen.

Das einfachste Verfahren ist das Zählverfahren. Dabei zählt man ab, wie oft man die Referenzspannung der niedrigsten Stelle addieren muß, um die Eingangsspannung zu erhalten. Die Zahl der Schritte ist das Ergebnis.

Das eingangs beschriebene Verfahren zur Wandlung eines Analogsignal in ein Digitalsignal ist eine besondere Art des Zählverfahrens, nämlich das sogenannte Multiple-Slope-Verfahren (vgl. die US - A - 4,357,600, die US - A - 4,268,820 und die Literaturstelle IEEE TRANSACTIONS ON INSTRUMENTATION AND MESSUREMENT, Bd. IM-34, Nr. 4, PT2, December 1985, NEW YORK, USA, Seiten 630 bis 635, TAHA: "Speed improvements for dual-slope a/d converters"). Hierbei handelt es sich um eine Weiterentwicklung des weiter unten noch näher erläuterten Zwei-Rampen-Verfahrens. Bei den verschiedenen Varianten des Multiple-Slope-Verfahrens wird mindestens eine Referenzspannung während der Aufintegrationszeit mehrmals einem Integrator zugeführt und abgeschaltet. Nach der Aufintegrationszeit wird nur eine Referenzspannung allein solange zugeführt, bis die Integratorspannung auf Null abintegriert ist. Das Multiple-Slope-Verfahren ermöglicht es, die Aufintegrationszeit unabhängig von der Aussteuerbarkeit des Integrators festzulegen.

Im folgenden wird nun zunächst anhand einer Zeichnung ein zum Stand der Technik gehörendes Zwei-Rampen-Verfahren und eine entsprechende, zum Stand der Technik gehörende Schaltungsanordnung beschrieben; es zeigen

Fig. 1     eine bevorzugte Ausführungsform einer Schaltungsanordnung zur Durchführung des Zwei-Rampen-Verfahrens,

Fig. 2     eine grafische Darstellung einer in ein digitales Ausgangssignal zu wandelnden Eingangsspannung und

Fig. 3     bei der Schaltungsanordnung nach Fig. 1 auftretende Integratorspannungen.

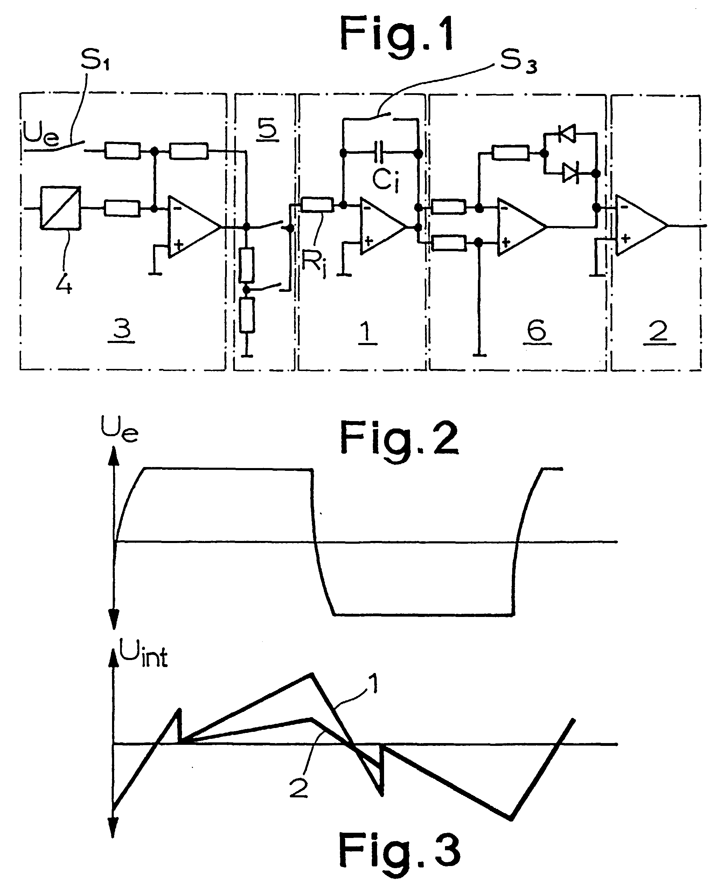

Die in Fig. 1 dargestellte Schaltungsanordnung zur Durchführung des Zwei-Rampen-Verfahrens weist zunächst funktionsnotwendig einen Integrator 1 und einen Komparator 2 auf. Zusätzlich sind vorgesehen ein Summationsverstärker 3 mit einem D/A-Wandler 4, der, durch einen nicht dargestellten Mikroprozessor gesteuert, die Referenzspannung ersetzt, ein 10:1-Teiler 5 zur Vergrößerung der Dynamik und schließlich ein +/_-Verstärker 6, damit der Komparator 2 immer einseitig angesteuert wird und damit der Einfluß von Offset und von Reaktionszeiten als additiver Anteil möglichst konstant gehalten werden kann.

Im Ruhezustand ist der Schalter $S_1$ offen, der Schalter $S_3$ geschlossen, der D/A-Wandler 4 nicht angesteuert; die Integratorspannung $U_{int}$ ist Null. Beim Meßbeginn wird ein ausgangsseitig vorhandener, nicht dargestellter Zähler, der Teil eines Mikroprozessors sein kann, gelöscht, der Schalter $S_3$ geöffnet und der Schalter $S_1$ geschlossen. Dadurch wird die Eingangsspannung $U_e$ während einer vorgegebenen Aufintegrationszeit $t_{auf}$, die mit Hilfe des nicht dargestellten Zählers gemessen wird, auf eine bestimmte Integratorspannung $U_{int}$ aufintegriert. Am Ende der Aufintegrationszeit $t_{auf}$ gilt für die Integratorspannung $U_{int}$:

$$U_{int}\left(t_{auf}\right) = \frac{-1}{R_i \cdot C_i} \cdot \int_0^{t_{auf}} U_e \cdot dt$$

Anschließend wird die Integratorspannung Uint während einer Abintegrationszeit tab durch den D/A-Wandler 4, der eine Referenzspannung $U_{ref}$ ersetzt, also praktisch durch eine Referenzspannung $U_{ref}$ auf Null abintegriert. Mit Hilfe des Komparators 2 und des nicht dargestellten Zählers wird die Abintegrationszeit $t_{ab}$ festgestellt. Es gilt

$$0 = \frac{-1}{R_i \cdot C_i} \int_0^{t_{ab}} U_{ref} \cdot dt + U_{int}\left(t_{auf}\right)$$

Damit bestimmt sich dann die Eingangsspannung $U_e$ wie folgt:

$$U_e = \frac{t_{ab}}{t_{auf}} \cdot U_{ref}$$

Der Vorteil des Zwei-Rampen-Verfahrens besteht darin, daß weder die Taktfrequenz, die allerdings stabil sein muß, noch die Integrationszeitkonstante in das Ergebnis eingehen. Im übrigen geht nicht der Momentanwert der Eingangsspannung in das Ergebnis ein, sondern nur ihr Mittelwert über die Aufintegrationszeit. Daher werden Wechselspannungen umso stärker abgeschwächt, je höher ihre Frequenz ist. Wechselspannungen, deren Frequenz gleich einem ganzzahligen Vielfachen des Kehrwerts der Aufintegrationszeit ist, werden vollständig unterdrückt. So kann der Einfluß der Brummspannung der Netzfrequenz durch die Wahl der Aufintegrationszeit beseitigt werden.

Für das bisher beschriebene Zwei-Rampen-Verfahren gilt folgendes:

a) Unterschiedliche Eingangsspannungen führen zu unterschiedlicher Aussteuerung des Integrators (siehe die Kurven 1 und 2 in Fig. 3).

b) Bei kleiner Aussteuerung des Integrators ist die Übersteuerungsfestigkeit des Integrators klein.

c) Kleine Aussteuerungen des Integrators führen automatisch zu dem Problem, eine Gleichspannungskompensation so durchzuführen, daß der Integrator immer um Null herum angesteuert wird.

d) Der D/A-Wandler erzeugt unterschiedliche Referenzspannungen. Lineare Abweichungen des D/A-Wandlers gehen somit direkt in das Ergebnis ein. Es muß ein D/A-Wandler mit hoher Auflösung und guter Linearität eingesetzt werden.

e) Zur Erweiterung der Dynamik ist ein hochgenauer 10:1-Teiler erforderlich.

f) Der +/_-Verstärker ist nötig, damit der Komparator immer einseitig angesteuert wird und damit man den Einfluß von Offset und von Reaktionszeiten möglichst als additiven Anteil konstanthalten kann.

Der Erfindung liegt nun die Aufgabe zugrunde, das zuvor im einzelnen beschriebene Verfahren zur Wandlung eines Analogsignals in ein Digitalsignal, also das Multiple-Slope-Verfahren als eine Art des Zählverfahrens, so auszugestalten und weiterzubilden, daß es mit einer einfacheren Schaltungsanordnung und besserem Ergebnis durchgeführt werden kann.

Das erfindungsgemäße Verfahren ist nun zunächst und im wesentlichen dadurch gekennzeichnet, daß die Integratorspannung von den der Eingangsspannung überlagerten Aussteuerimpulsen so beeinflußt wird, daß auch bei unterschiedlichen Eingangsspannungen stets eine zumindest nahezu gleiche Aussteuerung des Integrators erreicht wird. Damit entfallen die weiter oben beschriebenen, mit unterschiedlichen Aussteuerungen des Integrators verbundenen Nachteile des im Stand der Technik bekannten Zwei-Rampen- oder Multiple-Slope-Verfahrens. Der wesentliche Vorteil des erfindungsgemäßen Verfahrens gegenüber den bekannten Ausgestaltungen des Zwei-Rampen- oder Multiple-Slope-Verfahrens besteht darin, daß unabhängig von der Größe oder Polarität der Eingangsspannungen stets eine in Polarität und Größe zumindest nahezu gleiche Aussteuerung des Integrators gewährleistet wird.

Im einzelnen gibt es nun verschiedene Möglichkeiten, das erfindungsgemäße Verfahren auszugestalten und weiterzubilden, was im folgenden nur beispielhaft angesprochen werden soll.

Zunächst empfiehlt es sich, bei dem erfindungsgemäßen Verfahren der Eingangsspannung je nach Bedarf positive und/oder negative Aussteuerimpulse zu überlagern. Um stets - mehr oder weniger - zu der gleichen Integratorspannung zu kommen, kann es nötig sein, nur mit positiven Aussteuerimpulsen, nur mit negativen Aussteuerimpulsen oder mit positiven und mit negativen Aussteuerimpulsen zu arbeiten.

Damit erfindungsgemäß besonders "feinfühlig" gearbeitet werden kann, wird man mit Aussteuerimpulsen arbeiten, deren Impulsbreite klein ist gegenüber der Aufintegrationszeit. Wählt man Aussteuerimpulse mit einer - relativ zur Aufintegrationszeit - besonders geringen Impulsbreite, so können alle Aussteuerimpulse die gleiche Impulsbreite haben. Man benötigt dann jedoch unter Umständen eine große Anzahl von Aussteuerimpulsen. Deshalb geht eine weitere Lehre der Erfindung dahin, mit Aussteuerimpulsen zu arbeiten, deren Impulsbreite gesteuert wird. Die Steuerung der Impulsbreite kann insbesondere nach der Puls-Width-Modulation (PWM) erfolgen.

Insgesamt kann man dann, wenn man bei dem erfindungsgemäßen Verfahren die Anzahl und/oder die Polarität und/oder die Impulsbreite der Aussteuerimpulse steuert, das erfindungsgemäße Ziel, unabhängig von der Eingangsspannung zu einer vorgegebenen Integratorspannung zu kommen, nahezu beliebig genau erreichen.

Nach einer weiteren Lehre der Erfindung, der besondere Bedeutung zukommt, erfolgt bei der m-ten Wandlung das Steuern der Anzahl und/oder der Polarität und/oder der Impulsbreite der Aussteuerimpulse in Abhängigkeit davon, welche Integratorspannung bei der (m-1)-ten Wandlung erzielt worden ist; dies ist also ein iteratives Arbeiten.

Im folgenden wird nun das erfindungsgemäße Verfahren, wie das im Stand der Technik bekannte, von dem die Erfindung ausgeht, ein Zwei-Rampen-Verfahren, und eine erfindungsgemäße Schaltungsanordnung anhand einer Zeichnung nochmals und ergänzend beschrieben; es zeigen

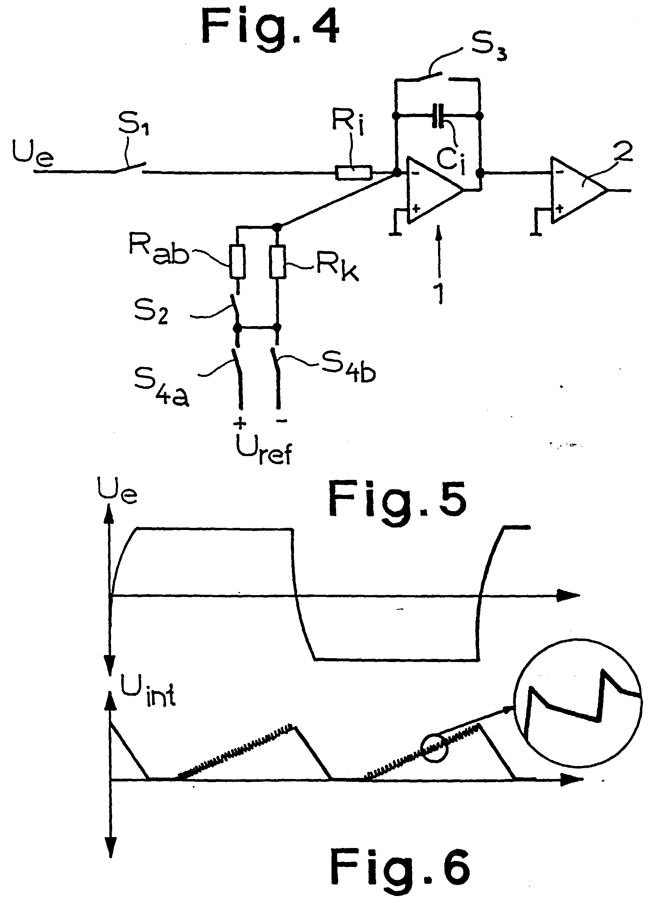

Fig. 4 eine bevorzugte Ausführungsform einer erfindungsgemäßen Schaltungsanordnung zur Durchführung des erfindungsgemäßen Verfahrens,

Fig. 5 eine - der Fig. 2 entsprechende - grafische Darstellung einer in ein digitales Ausgangssignal zu wandelnden Eingangsspannung,

Fig. 6 entsprechend Fig. 3, die bei der Schaltungsanordnung nach Fig. 4 auftretende Integratorspannung und

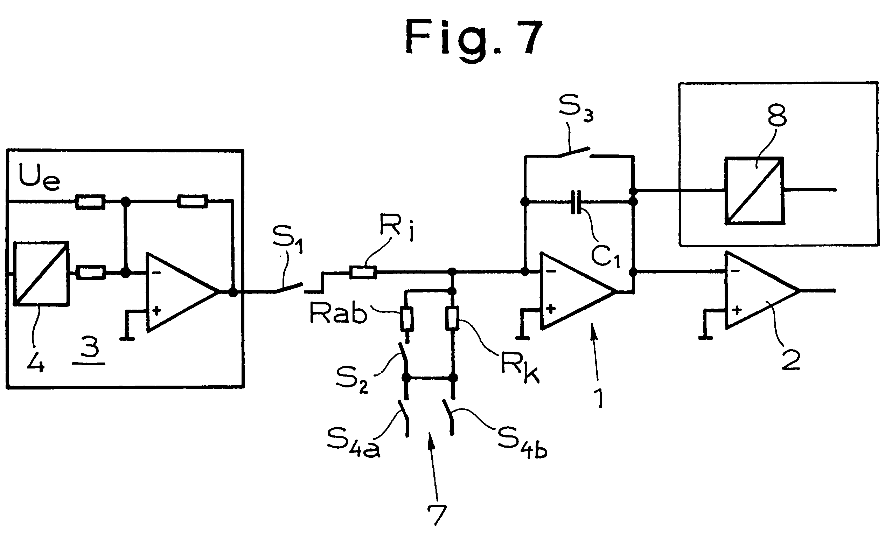

Fig. 7 eine ergänzte Ausführungsform einer erfindungsgemäßen Schaltungsanordnung zur Durchführung des erfindungsgemäßen Verfahrens.

Die in den Fig. 4 und 7 dargestellten Schaltungsanordnungen zur Durchführung des Zwei-Rampen-Verfahrens weisen zunächst wiederum, funktionsnotwendig, einen Integrator 1 und einen Komparator 2 auf. Zusätzlich ist ein Aussteuernetzwerk 7 vorgesehen, zu dem zwei Widerstände $R_{ab}$ und $R_k$ und drei Schalter $S_2$, $S_{4a}$ und $S_{4b}$ gehören und das einerseits an der Referenzspannung $U_{ref}$ liegt, andererseits an den Integrationseingang des Integrators 1 angeschlossen ist.

Im Ausführungsbeispiel nach Fig. 7 sind zusätzlich noch, wie im Stand der Technik, ein Summationsverstärker 3, zusätzlich außerdem ein A/D-Wandler 8 vorgesehen. Mit Hilfe des Summationsverstärkers 3 kann auch hier zur weiteren Erhöhung der Dynamik eine Gleichspannungskompensation durchgeführt werden. Da der eingestellte Wert über mehrere Messungen konstantgehalten und nur die Differenz von zwei Messungen bewertet wird, spielen Nichtlinearitäten des D/A-Wandlers 4 keine Rolle. Hier kann also ein sehr preiswerter D/A-Wandler 4 mit acht Bit eingesetzt werden. Der beim Ausführungsbeispiel nach Fig. 7 zusätzlich vorgesehene A/DWandler 8 dient der zusätzlichen Steigerung der Übersteuerungsfestigkeit des Integrators 1. Dazu wird die Integratorspannung während der Aufintegrationszeit ständig mit dem A/D-Wandler 8 gemessen. Weicht sie während der Aufintegrationszeit stark von Vorgabewerten ab, so werden die Aussteuerimpulse so beeinflußt, daß ein gültiges Spannungsfenster erreicht wird. Auch der A/D-Wandler 8 kann preiswert mit acht Bit gewählt werden.

Zur Funktionsweise des erfindungsgemäßen Verfahrens und der erfindungsgemäßen Schaltungsanordnungen folgendes:

Im Ruhezustand sind die Schalter $S_1$, $S_2$, $S_{4a}$ und $S_{4b}$ geöffnet, der Schalter $S_3$ geschlossen; die Integratorspannung $U_{int}$ ist Null. Beim Meßbeginn wird ein ausgangsseitig vorhandener, nicht dargestellter Zähler, der Teil eines Mikroprozessors sein kann, gelöscht, der Schalter $S_3$ geöffnet und der Schalter $S_1$ geschlossen. Während der jetzt beginnenden Aufintegrationszeit werden der Eingangsspannung $U_e$ - aus der Referenzspannung $U_{ref}$ abgeleitete - Aussteuerimpulse überlagert, und zwar dadurch, daß die Schalter $S_{4a}$ und $S_{4b}$ gesteuert geöffnet bzw. geschlossen werden. Am Ende der Aufintegrationszeit $t_{auf}$ wird der Schalter $S_1$ geöffnet. Danach werden die Schalter $S_2$ und $S_{4b}$ geschlossen, während der Abintegrationszeit $t_{ab}$ die Integratorspannung $U_{int}$ auf Null abintegriert. Danach gilt für die Eingangsspannung $U_e$:

$$U_e = \frac{U_{ref} \cdot t_{ab} \cdot \frac{1}{R_{ab}//R_k} - U_{ref} \cdot (t_{S_{4a}} - t_{S_{4b}}) \cdot n \cdot Zyklen \cdot \frac{1}{R_k}}{t_{auf} \cdot \frac{1}{R_i}}$$

**Patentansprüche**

1. Verfahren zur Wandlung eines Analogsignals in ein Digitalsignal, nämlich einer analogen Eingangsspannung in ein der Eingangsspannung proportionales digitales Ausgangssignal, bei dem die Eingangsspannung während einer vorgegebenen Aufintegrationszeit auf eine Integratorspannung aufintegriert wird, nach Ablauf der Aufintegrationszeit die Integratorspannung während einer Abintegrationszeit durch eine Referenzspannung auf Null abintegriert wird, aus dem Verhältnis von Abintegrationszeit zu Aufintegrationszeit, multipliziert mit der Referenzspannung die Eingangsspannung bestimmt wird und während der Aufintegrationszeit der Eingangsspannung Aussteuerimpulse überlagert werden, **dadurch gekennzeichnet**, daß die Integratorspannung von den der Eingangsspannung überlagerten Aussteuerimpulsen so beeinflußt wird, daß auch bei unterschiedlichen Eingangsspannungen stets eine zumindest nahezu gleiche Aussteuerung des Integrators erreicht wird.

2. Verfahren nach Anspruch 1, dadurch gekennzeichnet, daß der Eingangsspannung positive und/oder negative Aussteuerimpulse überlagert werden.

3. Verfahren nach Anspruch 1 oder 2, dadurch gekennzeichnet, daß die Impulsbreite der Aussteuerimpulse gesteuert wird.

4. Verfahren nach Anspruch 3, dadurch gekennzeichnet, daß die Steuerung der Impulsbreite der Aussteuerimpulse nach der Puls-Width-Modulation erfolgt.

5. Verfahren nach einem der Ansprüche 1 bis 4, dadurch gekennzeichnet, daß die Anzahl und/oder die Polarität und/oder die Impulsbreite der Aussteuerimpulse gesteuert wird.

6. Verfahren nach Anspruch 5, dadurch gekennzeichnet, daß bei der m-ten Wandlung das Steuern der Anzahl und/oder der Polarität und/ oder der Impulsbreite der Aussteuerimpulse in Abhängigkeit davon erfolgt, welche Integratorspannung bei der (m-1)-ten Wandlung erzielt worden ist.

7. Verfahren nach einem der Ansprüche 1 bis 6, dadurch gekennzeichnet, daß die Integratorspannung während der Aufintegrationszeit ständig - vorzugsweise mit einem A/D-Wandler - gemessen wird und dann, wenn die Integratorspannung während der Aufintegrationszeit von Vorgabewerten abweicht, die Aussteuerimpulse so beeinflußt werden, daß ein vorgegebenes Spannungsfenster erreicht wird.

## Claims

1. A method of converting an analogue signal into a digital signal, namely of converting an analogue input voltage into a digital output signal proportional to the input voltage, wherein the input voltage is integrated up to an integrator voltage over a predetermined integration time, after the integration time has elapsed the integrator voltage is de-integrated to zero over a de-integration time by a reference voltage, the input voltage is determined from the ratio of the de-integration time to the integration time multiplied by the reference voltage, and control pulses are superimposed on the input voltage during the integration time, **characterised in that** the integrator voltage is influenced by the control pulses superimposed on the input voltage so that control of the integrator which is at least approximately the same is always obtained, even when the input voltages are different.

2. A method according to claim 1, characterised in that positive and/or negative control pulses are superimposed on the input voltage.

3. A method according to claim 1 or 2, characterised in that the pulse width of the control pulses is controlled.

4. A method according to claim 3, characterised in that the pulse width of the control pulses is controlled by pulse width modulation.

5. A method according to any one of claims 1 to 4, characterised in that the number and/or the polarity and/or the pulse width of the control pulses is controlled.

6. A method according to claim 5, characterised in that at the mth conversion the number and/or the polarity and/or the pulse width of the control pulses are controlled depending on the integrator voltage which has been reached at the (m-1)th conversion.

7. A method according to any one of claims 1 to 6, characterised in that the integrator voltage is continuously measured during the integration time - preferably with an A-D converter - and if the integrator voltage departs from specified values during the integration time the control pulses are influenced so that a predetermined voltage window is reached.

## Revendications

1. Procédé pour la conversion d'un signal analogique en un signal numérique, plus précisément d'une tension d'entrée analogique en un signal de sortie numérique proportionnel à la tension d'entrée, dans lequel, pendant un temps d'intégration prédéfini, on attribue une intégration pour obtenir une tension d'intégration à la tension d'entrée; au terme du temps d'intégration, pendant un temps de désintégration, on soumet la tension d'intégration à une désintégration pour atteindre la valeur zéro, en passant par une tension de référence; on détermine la tension d'entrée à partir du rapport du temps de désintégration au temps d'intégration multiplié par la tension de référence; et, pendant le temps d'intégration, on superpose des impulsions de modulation à la tension d'entrée, caractérisé en ce que la tension d'intégration est influencée par les impulsions de modulation superposées à la tension d'entrée de telle sorte que, dans le cas de tensions d'entrée différentes, on obtient toujours une modulation de l'intégrateur au moins pratiquement égale.

2. Procédé selon la revendication 1, caractérisé en ce qu'on superpose à la tension d'entrée des impulsions de modulation positives et/ou négatives.

3. Procédé selon la revendication 1 ou 2, caractérisé en ce qu'on règle la largeur d'impulsion des impulsions de modulation.

4. Procédé selon la revendication 3, caractérisé en ce que le réglage de la largeur d'impulsion des impulsions de modulation a lieu conformément au procédé de "Puls-Width-Modulation".

5. Procédé selon les revendications 1 à 4, caractérisé en ce qu'on règle le nombre et/ou la polarité et/ou la largeur d'impulsion des impulsions de modulation.

6. Procédé selon la revendication 5, caractérisé en ce que, lors de la conversion du type m, le réglage du nombre et/ou de la polarité et/ou de la largeur d'impulsion des impulsions de modulation a lieu en fonction de la tension d'intégration que l'on a obtenue lors de la conversion de type (m-1).

7. Procédé selon l'une quelconque des revendications 1 à 6, caractérisé en ce qu'on mesure la tension d'intégration pendant le temps d'intégration en continu - de préférence avec un convertisseur analogique-numérique - et lorsque la tension d'intégration pendant le temps d'intégration s'écarte des valeurs prédéfinies, on influence les impulsions de modulation de telle sorte que l'on obtient une fenêtre de tension prédéfinie.

# Fig.1

# Fig.2

# Fig.3

# Fig.4

# Fig.5

$U_e$

$U_{int}$

# Fig.6

# Fig. 7

EP 0 530 666 B1